# EUROPEAN PATENT APPLICATION

(11) **EP 0 795 626 A1**
(43) Date of publication of application: **17.09.1997**
(21) Application number: 97300942.6
(22) Date of filing: 13.02.1997
(51) Int. Cl.: C23C 16/44

(54) **Method for suppressing detrimental effects of conductive deposits on interior surfaces of a plasma reactor**

(30) Priority: 26.02.1996 US 605507
(71) Applicant: APPLIED MATERIALS, INC., Santa Clara, California 95054-3299 (US)
(72) Inventor: Cohen, Barney, Santa Clara, CA 95051 (US); Guo, Ted, Palo Alto, CA 94303 (US)
(74) Representative: Bayliss, Geoffrey Cyril

(57) **Abstract**

The disclosure relates to a method for suppressing detrimental effects on the coupling of RF power into a plasma reactor (14) and the ignition of a plasma within the reactor caused by electrically conductive deposits on the internal surfaces of the reactor. Specifically, the method includes depositing a film of an electrically insulating material on the interior surfaces of the reactor (14) over the film of electrically conductive deposits. It has been found that this covering film suppresses the negative effects of the aforementioned film of electrically conductive deposits. The electrically conductive deposits are typically either particles of metal, semiconductor material, or both. They are usually deposited on the interior surfaces of the chamber as a result of etching processes performed on semiconductor production wafers within the reactor. The electrically insulating material which is deposited over the conductive deposits is preferably silicon dioxide. The above-described deposition step is terminated after an amount of the insulating material deposited on the interior surfaces of the reactor is sufficient to substantially eliminate the detrimental effects of the electrically conductive deposits. In addition, it is preferred that this amount be the minimum possible.

## Description

This invention relates to methods for enhancing the performance of a plasma reactor used for processes such as etching, chemical vapor deposition and the like on a semiconductor wafer held within the reactor. In particular, the invention is related to methods for sucoressing the detrimental effects on the coupling of Radio Frequency (RF) power into the reactor and on the ignition of a plasma within the reactor caused by conductive deposits on the reactor's internal surfaces.

A plasma reactor may be employed to perform a so-called "pre-clean" etch step to clean native oxides from semiconductor or metal surfaces on a water. Typically, the native oxides must be removed from a small portion of a metal layer (e.g., aluminum) or semiconductor substrate (e.g. silicon) exposed through a contact window of an overlying dielectric (e.g., silicon dioxide) layer. Usually, for example. an etchant gas such as Argon is introduced into the reactor chamber, a plasma is struck, and a RF power is imposed on the wafer to create a D.C. bias which attracts Argon ions to sputter etch the native oxides. The energy of the Argon ions is determined by the bias potential on the wafer. If the aspect ratio of the contact window (i.e., the ratio of the opening depth to the contact opening diameter) is relatively large (e.g., about 3:1), then a very high D.C. bias on the wafer (e.g., 400 volts) may be required to assure a complete removal of the native oxides. This is particularly true if the metal or silicon surface to be cleaned has a large amount of contamination thereon. Such a large aspect ratio is typical of semiconductor structures having multiple conductor layers connected by vias through an intervening dielectric layer.

A problem arises because the native oxides tend to be removed at different rates across the surface of the wafer. To ensure a complete removal of the native oxides, the etching process must be continued until all the metal or semiconductor surfaces have been thoroughly cleaned. Accordingly, the metal or semiconductor surfaces in some locations are exposed before the etching process is terminated. This causes an etching of these exposed surfaces, and particles of metal or semiconductor material tend to be propelled out into the reactor chamber where they deposit on the interior walls. This deposition problem is exacerbated as the D.C. bias is increased. The increased bias causes the Argon atoms to impact the aforementioned exposed metal and semiconductor surfaces with more momentum. The net result is an increased deposition of metal and semiconductor particles on the interior surfaces of the reactor.

The metal and semiconductor particles deposited on the interior surfaces of the chamber are electrically conductive. It has been found that the presence of these electrically conductive particles tends to interfere with the operation of the reactor chamber. For example, it has been found that these particles can reduce the efficiency of the capacitive coupling of RF power used to ignite of the plasma within the reactor, thereby increasing the power required to ignite and maintain the plasma. Similarly, in plasma reactors employing a RF antenna to inductively couple plasma source power into the chamber, it has been discovered that the aforementioned particles can reduce the efficiency of the inductive coupling , thereby decreasing the plasma ion density for a given amount of applied RF power. Further, it is believed the deposited conductive particles may change the reactor chamber impedance from a RF match condition and increase reflection of the RF power applied to the chamber back to the RF power source.

Thus, there is a need for a method of suppressing the detrimental influence of conductive metal or semiconductor particles deposited on the interior walls of a reactor chamber in order to avoid reduction of efficiency of the capacitive and inductive coupling of RF power into the chamber by the deposited conductive panicles.

The present invention is directed to methods including a chamber conditioning process for suppressing detrimental effects on the coupling of RF power into a plasma reactor and on the ignition of a plasma within the reactor, caused by electrically conductive deposits on the internal reactor surfaces. These electrically conductive deposits are typically either particles of metal, semiconductor material, or both, which have been deposited on the interior surfaces of the chamber as a result of etching processes performed on semiconductor production wafers within the reactor. The plasma reactor with which the aforementioned methods would typically be performed includes a reactor chamber, a gas source for supplying a process gas into the interior of the chamber, at least one electrical power supply for coupling electromagnetic power into the interior of the chamber so as to ignite and maintain a plasma of the processing gas, and a semiconductor wafer supporting pedestal located inside the chamber which has a conductive platen used to impart a bias potential on a semiconductor wafer held by the pedestal. This conductive platen may have a surface which is exposed to the interior of the chamber, or a layer of an electrically insulating material which covers the surface of the platen.

The chamber conditioning process of the present invention includes depositing a film of an electrically insulating material on the interior surfaces of the reactor over the detrimental electrically conductive deposits. This is accomplished by sputtering a surface comprised of an electrically insulating material which is either part of a blank oxide wafer installed in the chamber or a layer of insulating material covering the top of the pedestal itself. It has been found that the film of electrically insulating material suppresses the negative effects of the electrically conductive deposits. The electrically insulating material which is deposited over the conductive deposits is preferably silicon dioxide.

The chamber conditioning process is terminated after the amount of the insulating material deposited on the interior surfaces of the reactor becomes sufficient to substantially eliminate the detrimental effects of the conductive deposits. Further, it is preferred that the amount of deposited insulating material be the minimum necessary to substantially eliminate the detrimental effects of the conductive deposits. The reason it is preferred that only the minimum amount of insulating material be deposited before termination of the process stems from a need to periodically clean the interior chamber surfaces before the accumulation of deposited material (both insulating and conductive) reaches an excessive thickness which could result in its flaking off into the chamber and contaminating production wafers undergoing processing. Depositing the minimum amount of insulating material necessary minimizes the thickness of the material accumulation, and so delays the need to clean the deposits from of the interior chamber surfaces. In addition, minimizing the amount of insulating material deposited on the interior surfaces of the chamber also minimizes the amount of insulating material removed from the above-mentioned blank oxide wafer or layer of insulating material covering the top of the pedestal. This has a particular advantage in the case of a reactor having a pedestal with an insulating material covering layer as it reduces consumption of the layer, thereby prolonging the service life of the pedestal.

If the reactor employed is the type having a pedestal with an exposed conductive platen surface, the chamber conditioning process includes installing a blank oxide wafer into the reactor so as to completely cover this exposed conductive platen surface. The top surface of the blank oxide wafer is comprised of a film of an electrically insulating material, such as an oxide of silicon, facing the interior of the reactor. A process gas, which is preferably a sputter etchant gas such as Argon, is introduced into the chamber and a plasma is ignited to cause a sputter etching of the top surface of the blank oxide wafer. This removes the insulating material from the blank oxide wafer's top surface and deposits it on the interior surfaces of the reactor. However, if the reactor employed is the type having a pedestal with a conductive platen surface covered by a layer of electrically insulating material, the blank oxide wafer is not required. Instead, the insulating material is deposited on the interior chamber surfaces by sputter etching the top surface of the layer of insulating material covering the platen.

Typically, the chamber conditioning process will also include a step of imposing a DC bias on the blank oxide wafer or on the layer of insulating material covering the platen, as the case may be, to enhance the sputter etching process.

The step of terminating the chamber conditioning process is preferably accomplished by extinguishing the plasma. In the case where the reactor has a pedestal with an exposed conductive platen, extinguishing the plasma terminates the sputter etching of the blank oxide wafer. In the case where the reactor employed has a pedestal with an insulation-covered platen, extinguishing the plasma terminates the sputter etching of the insulating material covering the platen. As discussed previously, in both cases the conditioning process is preferably terminated as soon as the amount of the insulating material deposited on the interior surfaces of the reactor becomes sufficient to substantially eliminate the detrimental effects of the conductive deposits. This amount of deposited insulating material is preferably measured by equating it to a thickness of the top surface of the blank oxide wafer (or to a thickness of the insulating layer covering the platen) which has been removed during the conditioning process. Preferably, a thickness of between approximately 200 angstroms and approximately 1000 angstroms is removed. It is believed that for most applications the amount of insulating material deposited on the interior chamber surfaces when material is removed in the above range corresponds to the amount necessary to substantially eliminate the detrimental effects of the conductive deposits, while at the same time representing an acceptable minimum so as to postpone as much as possible the need to clean the chamber surfaces of deposits.

The chamber conditioning process is carried out after processing one or more production wafers where such processing causes electrically conductive particles to be deposited onto the interior chamber surfaces (e.g. "preclean" sputter etching of production wafers). It does not matter whether the conditioning process is performed for the first time, or if previous conditioning processes have be completed. Every time one or more production wafers are processed in a manner which produces conductive deposits on the interior chamber surfaces, the chamber conditioning process should be repeated. If not, the detrimental effects of the conductive deposits will re-emerge. The specific number of production wafers that can be processed before the chamber should be conditioned will depend upon the amount of conductive particles each production wafer deposits on the interior chamber surfaces. In turn, the amount of conductive particles each production wafer deposits will depend on the percentage of the wafer's exposed metal or semiconductor surface area in comparison to the overall surface area of the wafer. It is preferred that only one production wafer be processed before performing the chamber conditioning process where the area of the wafer having exposed metal or semiconductor surfaces equals or exceeds approximately 25 percent of the total area of the wafer's surface. If the exposed area is less than 25 percent of the total production wafer area, more than one production wafer can be processed before performing the chamber conditioning process. Although the exact number of production wafers that can be processed before performing the chamber conditioning process will vary depending on the quantity of conductive particles each deposits on the chamber walls, the plasma reactor may exhibit certain signs indicating the deposition of conductive particles has become detrimental. If one or more of these signs are exhibited, the conditioning process would preferably be performed. These signs include (i) a drop in level of RF power transmitted into the plasma reactor below a desired minimum, (ii) encountering significant difficulty in igniting the plasma within the reactor, and (iii) exceeding a desired maximum level of reflected RF power.

In addition to the just described benefits, other objectives and advantages of the present invention will become apparent from the detailed description which follows hereinafter when taken in conjunction with the drawing figures which accompany it.

The specific features, aspects, and advantages of the present invention will become better understood with regard to the following description, appended claims, and accompanying drawings where:

FIG. 1 is a simplified partially cut-away cross-sectional side view of an RF plasma reactor that can be utilized with a first method according to the present invention.

FIG. 2 is a block diagram of a first version of the chamber conditioning process of the present invention for use in the reactor of FIG. 1.

FIG. 3 is a simplified partially cut-away cross-sectional side view of an RF plasma reactor that can be utilized with a second method according to the present invention.

FIG. 4 is a block diagram of a second version of the chamber conditioning process of the present invention for use in the reactor of FIG. 3.

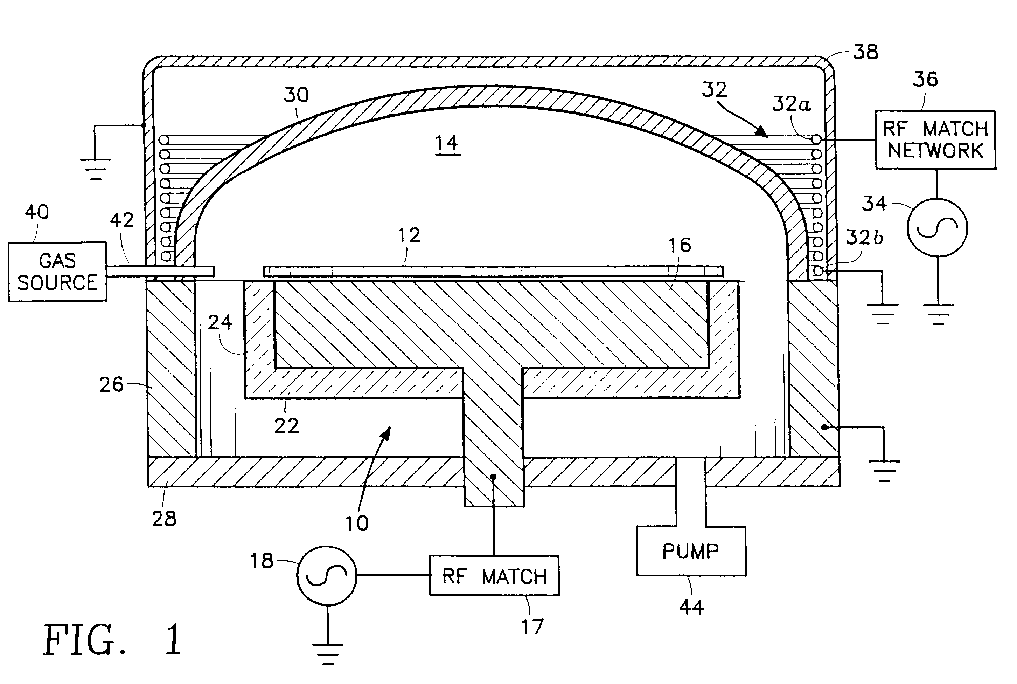

Preferred embodiments of a chamber conditioning process or method to suppress or substantially eliminate the detrimental effects of metal or semiconductor particles deposited on the interior walls of a plasma reactor will now be described in reference to the plasma etch reactor illustrated in FIG. 1. However, it should be noted that the depicted device is used only as an example of a plasma reactor which could be employed to perform the method according to the present invention. It is not intended that this method be limited solely to plasma reactors having the configuration shown in Fig. 1. Rather, the aforementioned preferred embodiments of this method could be employed in plasma reactors having other configurations as well.

The reactor of Fig. 1 includes a water pedestal 10 for supporting a wafer inside a reactor chamber 14. The wafer pedestal 10 has a conductive (e.g. aluminum or titanium) platen 16 which is connected through a conventional RF impedance matching network 17 to a conventional bias RF power source 18 controlling the voltage on the pedestal 10 so as to control the plasma D.C. bias potential. The plasma reactor chamber also includes a cylindrical conductive side wail 26, a base 28 and a multi-radius quartz dome 30 resting on the top of the side wall 26. The present invention may be used with either a capacitively coupled plasma reactor (e.g., of the type having a pair of RF excited electrodes) or an inductively coupled plasma reactor, or one capable of both as shown in Fig. 1. Capacitively coupling RF power into the chamber 14 to, for example. strike a plasma, is accomplished in accordance with well known methods using the RF power source 18 connected to the pedestal 10. For this purpose, the pedestal 10 constitutes one of a pair of electrodes and the conductive side wall 26 constitutes the opposite electrode. A cylindrical coil antenna 32 surrounding the dome 30 inductively couples RF power into the chamber 14. This antenna 32 has its topmost winding 32a connected to a plasma RF power source 34 through a RF matching network 36 and its lowest winding 32b connected to ground. A grounded RF shield 38 encloses the coil antenna 32. A gas source 40 provides a processing gas to the chamber 14 through a gas inlet 42. A pump 44 maintains the reactor chamber interior at a desired pressure.

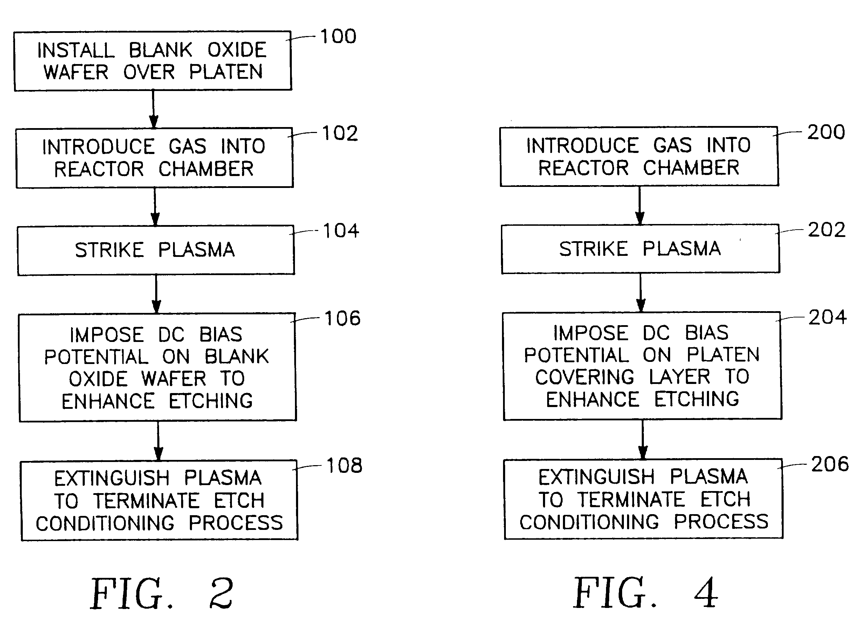

It has been found that by depositing a film of an electrically insulating material on the interior surfaces of the chamber over the deposited conductive metal and semiconductor particles, the previously-described detrimental effects of the conductive particles are suppressed or substantially eliminated. Specificaily, sputter etching a silicon dioxide (quartz) surface within the chamber disperses silicon dioxide particles into the chamber and depositing on the interior surfaces to form an electrically insulating film. These deposited silicon dioxide particles suppress or eliminate the detrimental effects of deposited conductive particles. The invention therefore concerns a chamber conditioning process for depositing an electrically insulating film onto internal chamber surfaces, in order to reduce or substantially eliminate the deleterious effects of deposited electrically conductive particles. The steps of a first preferred chamber conditioning process of the present invention for use in a plasma reactor such as the one shown in Fig. 1 are illustrated in Fig. 2. In a first step 100, a blank oxide wafer 12 (shown in Fig. 1 ) having a surface layer of silicon dioxide is placed over the exposed conductive platen 16, so that the platen 16 is completely covered. This prevents etching of any exposed portion of the platen 16 which would cause further deposition of conductive metal particles on the chamber surfaces. Next, in step 102, a process gas, preferably a sputter etchant gas such as Argon, is introduced into the chamber 14. Thereafter, a plasma is struck using well known methods of coupling RF power into the chamber 14, as shown in step 104. Preferably, RF power is also imposed on the blank oxide wafer to create a DC bias thereon of sufficient strength to attract Argon ions toward the blank oxide wafer 12, as shown in step 106, so as to enhance the sputter etching of its silicon dioxide surface layer. This sputter etching releases silicon dioxide particles into the chamber 14 which then deposit on the interior surfaces of the chamber 14.

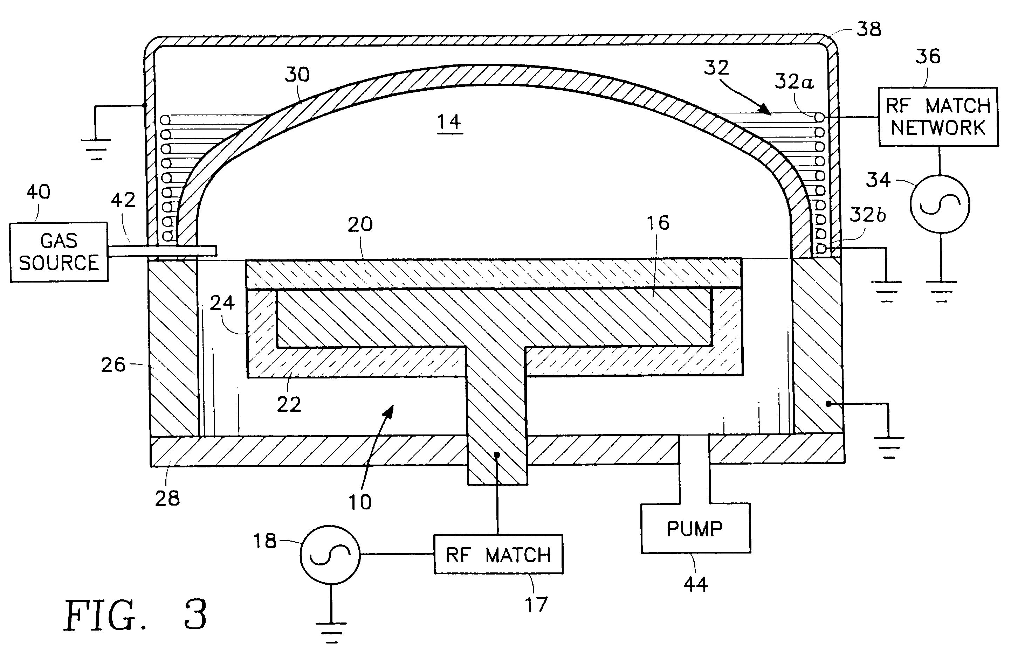

Some plasma reactors include a wafer pedestal 10 having a dielectric layer 20 covering the top face of the platen 16, as shown in Fig. 3. This covering layer 20 is preferably made of silicon dioxide, and is employed to prevent etching of the underlying platen 16 during etch operations carried out in the chamber 14. If the layer 20 completely covers the platen 16, as shown in Fig. 3, then the chamber conditioning process for suppressing the detrimental effects of deposited conductive particles can be performed without the use of a blank oxide wafer. Instead, the electrically insulating material of the layer 20 itself can be directly etched, thereby providing the necessary deposition of insulating particles on the interior chamber surfaces. This alternate chamber conditioning process has the advantage of eliminating the step of placing a blank oxide wafer onto the pedestal 10. Thus, the time required to perform the conditioning process is lessened. This alternate process is now described with reference to Fig. 4. A sputter etchant gas, such as Argon, is introduced into the chamber 14 (step 200). No blank oxide wafer is employed, and the pedestal 10 remains uncovered during the process. Next, in step 202, a plasma is struck within chamber 14. Preferably, the RF power applied to the pedestal 10 is adjusted to create a bias on the layer 20 covering the platen 16 of sufficient strength to attract ions from the plasma toward the pedestal 10 so that the surface of the covering layer 20 is sputter etched. The sputter etching of the layer 20 releases silicon dioxide particles into the chamber 14 which deposit on the interior surfaces thereof (step 204).

In the chamber conditioning process, deposition of electrically insulating material on the interior chamber surfaces is terminated by extinguishing the plasma, as illustrated in step 108 of Fig. 2 and step 206 of Fig. 4. Preferably, the process is terminated after the deposition of an amount of the electrically insulating material sufficient to substantially eliminate the detrimental effects of the previously deposited electrically conductive particles. The amount of insulating material deposited on the chamber interior surfaces is preferably measured by equating it to a thickness of the top surface of the blank oxide wafer 12 (of Fig. 1), or a thickness of the layer of insulating material 20 (of Fig. 3), removed during the chamber conditioning process. For typical blank oxide wafer diameters (e.g. 5-8 inches) and typical platen covering layer diameters (e.g. 9-11 inches), the preferred amount of insulating material considered sufficient to substantially eliminate the detrimental effects of the electrically conductive particles corresponds to a thickness of the insulating material removed from the blank oxide wafer 12 or layer 20 of between approximately 200 angstroms to approximately 1000 angstroms. It is believed that within this range sufficient insulating material is deposited on the interior chamber surfaces to achieve the desired substantial elimination of detrimental effects caused by the previously deposited conductive particles.

It is also desirable to minimize the amount of electrically insulating material deposited on the interior surfaces of the chamber 14 because deposits on these surfaces will eventually build up and have to be removed by cleaning the chamber 14. If the deposits are not removed, they can flake off and contaminate production wafers during processing. Minimizing the amount of insulating material deposited on the chamber surfaces minimizes the buildup on the material, and so extends the time between the required chamber cleaning operations. In this way, the reactor's productivity is maximized. In addition, when a plasma reactor (such as the one depicted in Fig. 3) having a layer 20 of electrically insulating material covering the platen 16 is employed, it is desirable to limit the removal of material from the layer 20 to extend the useful life of the pedestal 10. The smaller the amount of material removed from the layer 20 during each chamber conditioning process, the longer the pedestal 10 can remain in service before having to be replaced. It is believed that for most applications the amount of insulating material deposited on the interior chamber surfaces when material is removed in the aforementioned range represents an acceptable minimum so as to postpone as much as possible the need to clean the chamber surfaces of deposits and to prolong the service life of the pedestal 10.

The chamber conditioning process is preferably carried out after processing one or more production wafers when the processing is of a type which causes electrically conductive particles to be deposited onto the reactor's interior surfaces (e.g. "preclean" sputter etching of production wafers). It does not matter whether the conditioning process is performed for the first time, or if the conditioning process has been performed in the chamber numerous times. Every time one or more production wafers are processed in a manner which produces conductive deposits on the interior chamber surfaces, the chamber conditioning process should be repeated. If not, the detrimental effects of the conductive deposits will re-emerge. The specific number of production wafers that can be processed before the chamber 14 should be conditioned will depend upon the amount of conductive particles each production wafer deposits on the interior chamber surfaces. In turn, the amount of conductive particles each production wafer deposits will depend on the percentage of the wafer's exposed metal or semiconductor surface area in comparison to the overall surface area of the wafer.

For example, one typical wafer process involves the "pre-clean" etching of a so called "contact level" wafer. A "contact level" wafer is one which would typically have a relatively large area of exposed silicon (i.e., about 25% of the surface area of the wafer). It has been found that after the "pre-clean" processing of one such "contact level" wafer is complete, enough conductive particles have been deposited on the interior surfaces of the chamber that the coupling of RF power and the ability to ignite a plasma has been significantly degraded. Accordingly, it can also be concluded that the processing of only a single production wafer having a larger percentage of exposed metal or semiconductor surfaces would deposit enough conductive particles in the chamber to degrade the RF power coupling and plasma ignition capabilities of the reactor. In view of this, the chamber conditioning process is preferably performed after processing any production wafer having exposed metal or semiconductor surfaces equal to or exceeding approximately 25% of its total area. In addition, should a reactor having an exposed conductive platen 16 (such as shown in Fig. 1) be inadvertently activated in etch mode with no wafer installed, or where a production wafer being sputter etched does not completely cover the exposed platen, the conductive metal particles dispersed from the platen 16 could cause a heavy deposition on the interior chamber surfaces. Thus. in these cases also, it would be desirable to perform the chamber conditioning process before any further production wafer processing.

If the exposed metal and semiconductor surface area is less than about 25% of the total production wafer area, it is believed more than one production wafer can be processed before performing the chamber conditioning process. This is because processing a production wafer having less than about 25% exposed semiconductor or metallic surface area (e.g., a "via-type" wafer having approximately 1% exposed metallic surface area) may not cause conductive depositions extensive enough to immediately affect the operations of the reactor. Accordingly, the performance of the chamber conditioning process could be delayed until some number of production wafers had been processed. This delay is advantageous as it would improve wafer throughput time. The exact number of production wafers that can be processed before performing the chamber conditioning process will vary depending upon the percentage of the exposed semiconductor or metallic surface area associated with each wafer processed. However, it is believed certain warning signs may occur which would indicate an immediate need to perform the chamber conditioning process. First, if it becomes increasing difficult to strike and maintain the plasma, this would be an indication that the process should be employed. In addition, if the level of RF power coupled into the chamber is monitored directly, a significant drop would indicate the deposited electrically conductive particles have become a problem. Accordingly, if the detected power level drops below a desired threshold, the chamber conditioning process should be performed immediately. It is also believed that the reflected power levels may increase, thereby providing an indirect indicator of a reduction in RF power coupling into the chamber. The reflected power level can be monitored and the chamber conditioning process performed upon a significant rise in the reflected power exceeding a desired threshold. The aforementioned thresholds would depend on the type of reactor employed, the processes being performed, as well as other well known factors. However, in general, these thresholds would respectively correspond to a minimum acceptable level of RF power coupling into the chamber and a maximum acceptable reflected power level.

The methods of Figs. 2 and 4, are preferably performed with a chamber pressure in the range of approximately 0.8- 20 mTorr. In addition, the flow rate of the preferred Argon gas should be approximately 5 - 300 sccm. although a higher rate of 50 - 300 would be preferred. Sufficient RF energy should be coupled into the chamber from one or more power supplies such that, in view of the chamber pressure and gas flow rate, a preferred etch rate of approximately 500 angstroms per minute is maintained.

While the invention has been described in detail by reference to the preferred embodiment described above, it is understood that variations and modifications thereof may be made without departing from the true spirit and scope of the invention.

## Claims

1. A method for suppressing detrimental effects on the coupling of RF power into a plasma reactor and the ignition of a plasma within the reactor caused by electrically conductive deposits on the internal surfaces of the reactor, the method comprising the step of:
depositing a film of an electrically insulating material on the interior surfaces of the reactor over the film of electrically conductive deposits.

2. The method of Claim 1 wherein said depositing step comprises the steps of:
providing a target surface comprised of the electrically insulating material within the reactor;
introducing an etchant gas into the reactor; and
igniting a plasma within the reactor to cause a sputter etching of the target surface, thereby resulting in the depositing of the film electrically insulating material on the interior surfaces of the reactor.

3. The method of Claim 1, wherein the electrically conductive deposits comprises particles consisting of at least one of (i) a metal, and (ii) a semiconductor material, which were deposited on the interior surfaces of the reactor as a result of at least one etching process performed within the reactor.

4. The method of Claim 1, wherein the film of electrically insulating material comprises particles of silicon dioxide.

5. The method of Claim 1, further comprising the step of terminating the deposition of the electrically insulating material after an amount deposited on the interior surfaces of the reactor is sufficient to substantially eliminate the detrimental effects of the electrically conductive deposits.

6. The method of Claim 5, wherein the terminating step is performed whenever the amount of electrically insulating material deposited is a minimum sufficient to substantially eliminate the detrimental effects of the electrically conductive deposits.

7. The method of Claim 1, wherein the reactor has a wafer holding pedestal comprising an electrically conductive platen having an exposed surface facing the interior of the reactor, and wherein the depositing step comprises:
installing a blank oxide wafer into the reactor, the wafer comprising a bottom surface which completely covers the exposed surface of the platen and a too surface comprising the electrically insulating material which faces the interior of the reactor;
introducing an etchant gas into the reactor; and
igniting a plasma within the reactor to cause a sputter etching of the top surface of the blank oxide wafer, thereby resulting in said depositing of the film of electrically insulating material on the interior surfaces of the reactor.

8. The method of Claim 7, wherein the depositing step further comprises imposing a DC bias potential on the blank oxide wafer to enhance the sputter etching of the blank oxide wafer.

9. The method of Claim 7, further comprising the step of:
extinguishing the plasma to terminate the sputter etching of the blank oxide wafer after a prescribed thickness of the top surface of the wafer has been removed.

10. The method of Claim 9, wherein the prescribed thickness is between approximately 200 angstroms and approximately 1000 angstroms.

11. The method of Claim 1, wherein the reactor has a wafer holding pedestal comprising an electrically conductive platen having a covering layer of the electrically insulating material which faces the interior of the reactor, and wherein the depositing step comprises:
introducing an etchant gas into the reactor: and
igniting a plasma within the reactor to cause a sputter etching of the layer of electrically insulating material, thereby resulting in said depositing of the film of material on the interior surfaces of the reactor.

12. The method of Claim 11, wherein the depositing step further comprises imposing a DC bias potential on the layer of electrically insulating material to enhance the sputter etching thereof.

13. The method of Claim 11, further comprising the step of:
extinguishing the plasma to terminate the sputter etching of the layer of electrically insulating material after a prescribed thickness thereof has been removed.

14. The method of Claim 13, wherein the prescribed thickness is between approximately 200 angstroms and approximately 1000 angstroms.

15. The method of Claim 1, wherein the electrically conductive deposits results from the etching of semiconductor production wafers each having an exposed surface facing the interior of the reactor, said surface comprising a first portion consisting of at least one of (i) a metal, and (ii) a semiconductor material, and wherein the depositing step is performed whenever a prescribed number of the semiconductor production wafers have undergone etching within the reactor.

16. The method of Claim 15, wherein the prescribed number of production wafers is one whenever said first portion of the wafer equals or exceeds approximately 25 percent of the total area of the exposed surface of the wafer.

17. The method of Claim 15, wherein the prescribed number of production wafers is more than one whenever said first portion of the wafer amounts to less than about 25 percent of the total area of the exposed surface of the wafer.

18. The method of Claim 1, wherein the depositing step is performed whenever at least one of the following conditions is exhibited, (i) the coupling of RF power into the plasma reactor drops below a desired minimum level, (ii) significant difficulty is encountered in igniting the plasma within the reactor, and (iii) reflected RF power exceeds a desired maximum level.

19. In a plasma reactor comprising a reactor chamber, a gas source for supplying a process gas into the interior of the chamber, at least one electrical power supply for coupling electromagnetic power into the interior of the chamber so as to ignite and maintain a plasma of the process gas, and a semiconductor wafer supporting pedestal inside the chamber comprising a conductive platen, a chamber conditioning method for suppressing detrimental effects on the coupling of RF power into the reactor chamber and the ignition of a plasma within the chamber caused by electrically conductive deposits on the internal surfaces of the chamber, the method comprising the steps of:
depositing a film of an electrically insulating material on the interior surfaces of the reactor over the electrically conductive deposits; and,
terminating the deposition of the electrically insulating material after an amount thereof deposited on the interior surfaces of the reactor is sufficient to substantially eliminate the detrimental effects of the electrically conductive deposits.

20. The method of Claim 19, wherein said depositing step comprises the steps of:
providing a target surface comprised of the electrically insulating material within the reactor;
introducing an etchant gas into the reactor; and
igniting a plasma within the reactor to cause a sputter etching of the target surface, thereby resulting in the depositing of the film electrically insulating material on the interior surfaces of the reactor.

21. The method of Claim 19, wherein the step of terminating the deposition of the electrically insulating material is performed whenever the amount thereof deposited on the interior surfaces of the reactor is a minimum sufficient to substantially eliminate the detrimental effects of the electrically conductive deposits.

22. The method of Claim 19, wherein the depositing step comprises:
installing a blank oxide wafer onto the pedestal, the blank oxide wafer comprising a bottom surface which completely covers the exposed surface of the platen and a top surface comprising the electrically insulating material which faces the interior of the reactor;
introducing the process gas into the reactor, said process gas being a sputter etchant gas;
igniting a plasma within the reactor to cause a sputter etching of the top surface of the blank oxide wafer; and
imposing a DC bias potential on the blank oxide wafer to enhance the sputter etching of the blank oxide wafer.

23. The method of Claim 22, wherein the step of terminating the deposition of the electrically insulating material comprises extinguishing the plasma to terminate the sputter etching of the blank oxide wafer after a prescribed thickness of the top surface of the wafer has been removed.

24. The method of Claim 23, wherein the prescribed thickness is between approximately 200 angstroms and approximately 1000 angstroms.

25. The method of Claim 19, wherein the pedestal further comprises a layer of the electrically insulating material which faces the interior of the reactor and covers the platen, and wherein the depositing step comprises:
introducing the process gas into the reactor chamber, said process gas being a sputter etchant gas:
igniting a plasma within the reactor to cause a sputter etching of the layer of electrically insulating material; and
imposing a DC bias potential on the layer of electrically insulating material to enhance the sputter etching of the layer of electrically insulating material.

26. The method of Claim 25, wherein the step of terminating the deposition of the electrically insulating material comprises extinguishing the plasma to terminate the sputter etching of the layer of electrically insulating material after a prescribed thickness of a top surface thereof has been removed.

27. The method of Claim 26, wherein the prescribed thickness is between approximately 200 angstroms and approximately 1000 angstroms.

28. The method of Claim 19, wherein the electrically conductive deposits result from etching of semiconductor production wafers held by the pedestal, each having an exposed surface facing the interior of the reactor, said exposed surface comprising a first portion consisting of at least one of (i) a metal, and (ii) a semiconductor material, and wherein the depositing step is performed whenever a prescribed number of semiconductor production wafers have undergone etching within the reactor chamber.

29. The method of Claim 28, wherein the prescribed number of production wafers is one whenever said first portion of the wafer equals or exceeds approximately 25 percent of the total area of the exposed surface of the wafer.

30. The method of Claim 28, wherein the prescribed number of production wafers is more than one whenever said first portion of the wafer amounts to less than about 25 percent of the total area of the exposed surface of the wafer.

31. The method of Claim 19, wherein the depositing step is performed whenever at least one of the following conditions is exhibited, (i) the coupling of RF power into the plasma reactor drops below a desired minimum level, (ii) significant difficulty is encountered in igniting the plasma within the reactor, and (iii) reflected RF power exceeds a desired maximum level.

32. In a plasma reactor comprising a reactor chamber, a gas source for supplying a process gas into the interior of the chamber, at least one electrical power supply for coupling electromagnetic power into the interior of the chamber so as to ignite and maintain a plasma of the process gas, and a semiconductor wafer supporting pedestal inside the chamber comprising a conductive platen, a method for suppressing detrimental effects on the coupling of RF power into the reactor chamber and the ignition of a plasma within the chamber caused by electrically conductive deposits on the internal surfaces of the chamber, the method comprising the steps of:
processing at least a one semiconductor production wafer in a manner which causes the deposition of the electrically conductive deposits on the internal surfaces of the chamber; and
performing a chamber conditioning process comprising the steps of,
depositing a film of an electrically insulating material on the interior surfaces of the reactor over the electrically conductive deposits; and,
terminating the deposition of the electrically insulating material after an amount thereof deposited on the interior surfaces of the reactor is sufficient to substantially eliminate the detrimental effects of the electrically conductive deposits.
